# EUROPÄISCHE PATENTSCHRIFT

(11) **EP 3 730 986 B1**
(45) Veröffentlichungstag und Bekanntmachung des Hinweises auf die Patenterteilung: **15.02.2023**
(21) Anmeldenummer: 19170813.0
(22) Anmeldetag: 24.04.2019
(51) Int. Cl.: H05K 13/04, G02B 7/00, B23Q 1/01, G02B 7/182, G02B 21/34

(54) **KOPPLUNGSGLIED FÜR EINE POSITIONIEREINRICHTUNG, POSITIONIEREINRICHTUNG MIT EINEM KOPPLUNGSGLIED, SOWIE FERTIGUNGSVERFAHREN**
COUPLER FOR A POSITIONING DEVICE, POSITIONING DEVICE WITH A COUPLER, AND PRODUCTION METHOD
ORGANE DE COUPLAGE POUR UN DISPOSITIF DE POSITIONNEMENT, DISPOSITIF DE POSITIONNEMENT DOTÉ D'UN ORGANE DE COUPLAGE AINSI QUE PROCÉDÉ DE FABRICATION

(43) Veröffentlichungstag der Anmeldung: 28.10.2020
(73) Patentinhaber: ETEL S.A., 2112 Môtiers (CH)
(72) Erfinder: GALDOS, Gorka, 2108 Couvet (CH); TAMIGNIAUX, Philippe, 25500 Morteau (FR); ZANONI, Pierre-André, 1400 Yverdon (CH); BORDAS, Jean-Yves, 25300 Pontarlier (FR)
(74) Vertreter: Maikowski & Ninnemann Patentanwälte Partnerschaft mbB

(56) Entgegenhaltungen:
- EP-A1- 1 420 179
- EP-A1- 1 810 776
- FR-A1- 2 861 715
- US-A1- 2008 216 286

## Beschreibung

Diese Schrift betrifft Ausfiihrungsformen eines Kopplungsglieds für eine Positioniereinrichtung, insbesondere eine Positioniereinrichtung in Portalbauweise (bekannt auch als sog. Gantry System), z.B. einen XY-Tisch, Ausfiihrungsformen einer Positioniereinrichtung mit einem Kopplungsglied sowie Ausführungsformen eines Verfahrens zur Fertigung eines Kopplungsglieds für eine Positioniereinrichtung.

Bei einer beispielhaften Positioniereinrichtung, insbesondere einer Positioniereinrichtung in Portalbauweise, wie in der EP 2 066 996 B1 beschrieben, ist zwischen zwei (oder mehr) parallelen Linearführungen ein Querbalken beweglich gelagert, auf welchem mittels einer weiteren Linearführung ein Funktionselement beweglich gelagert ist, so dass dieses Funktionselement in einer Ebene zwischen den beiden parallelen Linearführungen (bekannt auch als sog. H-Portal) frei positionierbar ist.

Das Funktionselement kann - je nach Anwendung - beispielsweise ein Greifer eines Bestückungsautomaten, ein Mikroskop, ein Laser eines Laser - Bearbeitungszentrums oder auch ein Tastsystem einer Koordinatenmessmaschine sein. Viele weitere Anwendungen sind bekannt.

In allen diesen Anwendungen, von denen es für Positioniereinrichtungen noch einige mehr gibt, spielt die möglichst genaue Positionierung des Funktionselements eine wichtige Rolle. Daher wird mitunter Aufwand betrieben, um mit Hilfe von möglichst genauen Positionsmessgeräten das Funktionselement möglichst genau zu positionieren, was beispielsweise in der EP 2 066 996 B1 näher ausgeführt ist.

Aber nicht nur eine genaue Positionsmessung kann für eine genaue Positionierung wichtig sein, sondern auch die Ausgestaltung der Kopplung zwischen den senkrecht zueinander liegenden Linearführungen. Aufgrund der Beschleunigungen in die zueinander senkrecht liegenden Richtungen kann es, je nach Steifigkeit der betreffenden Komponenten, zu Verschwenkungen des Funktionselement bzw. der diesen tragenden Linearführung kommen, beispielsweise um die Y-Achse bei einer Beschleunigung (darunter fällt auch ein Bremsvorgang) entlang der X-Achse, aber auch um die vertikale Z-Achse, z.B. bei nicht exakt synchroner Bewegung der den Querbalken tragenden zwei (oder mehr) parallelen Linearführungen in X-Richtung.

Die Zulassung einer begrenzten Verschwenkung des das Funktionselement tragenden Querbalken um die vertikale Z-Achse ist mitunter erwünscht, da unter Umständen ein exakt synchroner Betrieb der den Querbalken tragenden zwei (oder mehr) parallelen Linearführungen nicht zu jedem Zeitpunkt gewährleistet ist, z.B. gerade aufgrund einer angestrebten geringfügigen Verschwenkung des Funktionselements, wie in der EP 2 066 996 B1 in Abs. 0040 ausgeführt ist.

Hingegen sind die übrigen Verschwenkungen üblicherweise unerwünscht, da sie eine genaue Positionierung des Funktionselements erschweren.

Die US 2008/216286 A1 und die EP 1 420 179 A1 beschreiben jeweils eine Kopplungseinrichtung mit Blattfedern. Ferner beschreiben die EP 1 810 776 A1 und FR 2 861 715 A1 eine Kopplungseinrichtung in Portalbauweise, welche jeweils auf Schienen bzw. auf einem Schlitten geführt sind.

Aufgabe der vorliegenden Erfindung ist es, ein Kopplungsglied für eine Positioniereinrichtung, insbesondere eine Positioniereinrichtung in Portalbauweise (bekannt auch als sog. Gantry System), z.B. einen XY-Tisch, vorzuschlagen, der in Hinblick auf gewünschte und unerwünschte Verschwenkungen verbesserte Steifigkeitseigenschaften aufweist.

Aufgabe der vorliegenden Erfindung ist es weiter, eine entsprechende Positioniereinrichtung sowie ein entsprechendes Fertigungsverfahren vorzuschlagen.

Hiervon ausgehend werden die Gegenstände der unabhängigen Ansprüche vorgeschlagen. Merkmale einiger Ausführungsbeispiele sind in den Unteransprüchen angegeben. Die Merkmale der Unteransprüche können miteinander zur Ausbildung weiterer Ausführungsfonnen kombiniert werden, sofern nicht ausdrücklich etwas anderes angegeben ist.

Gemäß einem ersten Aspekt wird ein Kopplungsglied für eine Positioniereinrichtung vorgeschlagen, die eine erste Linearführung zur Führung eines ersten Laufwagens entlang einer ersten Linearrichtung sowie eine zweite Linearführung zur Führung eines zweiten Laufwagens entlang einer zweiten, zur ersten Linearrichtung im Wesentlichen senkrechten Linearrichtung umfasst. Das Kopplungsglied ist für eine Ausbildung einer Kopplung zwischen dem ersten Laufwagen und der zweiten Linearführung ausgestaltet. Das Kopplungsglied umfasst ein Zentralteil; ein in einem Abstand zu dem Zentralteil angeordnetes und das Zentralteil umgebendes Umgebungsteil, wobei das Umgebungsteil einen zentralen, das Zentralteil umgebenen Abschnitt sowie zwei, in erster Linearrichtung an den zentralen Abschnitt angrenzende Endabschnitte aufweist; eine Mehrzahl von den Abstand ausbildenden Verbindungsblattfedern, die das Zentralteil und den zentralen Abschnitt des Umgebungsteil miteinander verbinden, wobei sich die Ebenen, in denen die Verbindungsblattfedern angeordnet sind, in einem Zentrum des Zentralteils schneiden; und, an jedem der beiden Endabschnitte des Umgebungsteils, eine parallel zur ersten Linearrichtung angeordnete Vertikalblattfeder.

Gemäß einem zweiten Aspekt umfasst eine Positioniereinrichtung eine erste Linearführung zur Führung eines ersten Laufwagens entlang einer ersten Linearrichtung; eine zweite Linearführung zur Führung eines zweiten Laufwagens entlang einer zweiten, zur ersten Linearrichtung im Wesentlichen senkrechten Linearrichtung; und ein Kopplungsglied, das für eine Ausbildung einer Kopplung zwischen dem ersten Laufwagen und der zweiten Linearführung ausgestaltet ist. Das Kopplungsglied umfasst ein Zentralteil; ein in einem Abstand zu dem Zentralteil angeordnetes und das Zentralteil umgebendes Umgebungsteil, wobei das Umgebungsteil einen zentralen, das Zentralteil umgebenen Abschnitt sowie zwei, in erster Linearrichtung an den zentralen Abschnitt angrenzende Endabschnitte aufweist; eine Mehrzahl von den Abstand ausbildenden Verbindungsblattfedern, die das Zentralteil und den zentralen Abschnitt des Umgebungsteil miteinander verbinden, wobei sich die Ebenen, in denen die Verbindungsblattfedern angeordnet sind, in einem Zentrum des Zentralteils schneiden; und, an jedem der beiden Endabschnitte des Umgebungsteils, eine parallel zur ersten Linearrichtung angeordnete Vertikalblattfeder.

Gemäß einem dritten Aspekt wird ein Verfahren zur Fertigung eines Kopplungsglieds für eine Positioniereinrichtung vorgeschlagen. Die Positioniereinrichtung umfasst eine erste Linearführung zur Führung eines ersten Laufwagens entlang einer ersten Linearrichtung sowie eine zweite Linearführung zur Führung eines zweiten Laufwagens entlang einer zweiten, zur ersten Linearrichtung im Wesentlichen senkrechten Linearrichtung. Das Verfahren umfasst: Fertigen, aus einem Stück, eines Zentralteils; eines in einem Abstand zu dem Zentralteil angeordneten und das Zentralteil umgebenden Umgebungsteils, wobei das Umgebungsteil einen zentralen, das Zentralteil umgebenen Abschnitt sowie zwei, in erster Linearrichtung an den zentralen Abschnitt angrenzende Endabschnitte aufweist; einer Mehrzahl von den Abstand ausbildenden Verbindungsblattfedern, die das Zentralteil und den zentralen Abschnitt des Umgebungsteil miteinander verbinden, wobei sich die Ebenen, in denen die Verbindungsblattfedern angeordnet sind, in einem Zentrum des Zentralteils schneiden; und, an jedem der beiden Endabschnitte des Umgebungsteils, einer parallel zur ersten Linearrichtung angeordneten Vertikalblattfeder.

Bei den drei oben beschriebenen Aspekten ist jeweils vorgesehen, dass sich auch die Ebenen, in denen die Vertikalblattfedern angeordnet sind, in dem Zentrum des Zentralteils schneiden, so dass die Verbindungsblattfedern und die Vertikalblattfedern für eine Verschwenkung des Umgebungsteils um eine das Zentrum des Zentralteils durchquerende und parallel zu einer dritten Linearrichtung befindliche Rotationsachse ausgestaltet sind.

Nachstehend wird auf alle vorstehend genannten Aspekte Bezug genommen werden.

Aufgrund des Designs des Kopplungsglieds wird eine hohe Steifigkeit erzielt, insbesondere betreffend eine - in der Regel nicht gewünschte - Verschwenkung um die zweite Linearrichtung. Demgegenüber ist eine - in der Regel gewünschte - Verschwenkung um eine dritte Linearrichtung, die senkrecht zur sowohl der ersten Linearrichtung als auch der zweiten Linearrichtung (also beispielsweise eine Vertikalrichtung) ist, zu einem gewissen Grad möglich, was an anderer Stelle noch näher ausgeführt werden wird.

Die Positioniereinrichtung, in der das Kopplungsglied eingesetzt werden kann, ist beispielsweise als Positioniereinrichtung in Portalbauweise (bekannt auch als sog. Gantry System) ausgebildet. Beispielsweise handelt es sich bei der Positioniereinrichtung um einen sog. XY-Tisch bzw. um ein sog. H-Portal.

Die erste Linearführung führt die zweite Linearführung entlang der ersten Linearrichtung, üblicherweise mittels eines entsprechend ausgebildeten Elektroantriebs. Wie mit Bezug auf die Ausführungsbeispiele in den Zeichnungen noch näher ausgeführt werden wird, kann die Positioniereinrichtung auch mehrere erste Linearführungen umfassen.

Die zweite Linearführung führt den zweiten Laufwagen entlang der zweiten Linearrichtung im Wesentlichen senkrecht zur ersten Linearrichtung. Die zweite Linearführung ist beispielsweise als ein Querbalken ausgebildet, der oberhalb der ersten Linearführung(en) angeordnet ist und am ersten Laufwagen angreift, beispielsweise so, dass er die erste(n) Linearführung(en) überbrückt. Auf diese Weise entsteht das besagte H-Portal. Zur Führung des zweiten Laufwagens umfasst die zweite Linearführung üblicherweise einen entsprechend ausgebildeten Elektroantrieb.

An dem zweiten Laufwagen kann ein Funktionselement angeordnet sein, beispielsweise in Gestalt eines Bestückungsgeräts, eines Mikroskops, eines Lasers, usw. Positioniereinrichtungen der vorgenannten Art kommen in einem großen Anwendungsbereich zum Einsatz, und entsprechend vielfältig sind die Möglichkeiten zur Ausgestaltung des Funktionselements. Die hier beschriebenen Aspekte sind auf keine bestimmte Anwendung eingeschränkt. Das Funktionselement kann darüber hinaus mit einem weiteren Elektroantrieb ausgestattet sein, der eine Führung einer Funktionseinheit (beispielsweise ein Bestückungskopf, ein Greifer oder dergleichen) entlang einer weiteren Richtung, z.B. der dritten Linearrichtung führen kann.

Das Kopplungsglied ist für die Ausbildung der Kopplung zwischen dem ersten Laufwagen (der von der ersten Linearführung geführt wird) und der zweiten Linearführung ausgestaltet. Die zweite Linearführung kann mit Hilfe des ersten Laufwagens entlang der ersten Linearrichtung bewegt werden, und die dafür notwendige Kopplung zwischen der zweiten Linearführung und dem ersten Laufwagen ist insbesondere mittels des Kopplungsgebiets ausgebildet.

Nach einer Ausführungsform ist das Kopplungsglied an der zweiten Linearführung befestigt. Am ersten Laufwagen kann ein Aufnahmeglied befestigt sein, und das Aufnahmeglied ist in dieser Ausführungsform für eine Aufnahme des Kopplungsglieds ausgebildet. Alternativ ist das Kopplungsglied unmittelbar - also ohne ein zusätzliches Aufnahmeglied - am ersten Laufwagen befestigt.

Nach einer Ausführungsform der Positioniereinrichtung sind sowohl das Zentralteil als auch das Umgebungsteil des Kopplungsglieds an dem (am ersten Laufwagen befestigten) Aufnahmeglied befestigt, wobei ausschließlich das Umgebungsteil, nicht aber das Zentralteil an der zweiten Linearführung befestigt ist.

Das Umgebungsteil lässt sich räumlich in einen zentralen, das Zentralteil umgebenden Abschnitt sowie in zwei, in erster Linearrichtung an den zentralen Abschnitt angrenzende Endabschnitte unterteilen, wobei die Endabschnitte im Vergleich zum zentralen Abschnitt jeweils in zweiter Linearrichtung verjüngt sein können.

Der zentrale Abschnitt kann sich spiegelsymmetrisch (bezogen auf die dritte Linearrichtung) um das Zentralteil erstrecken, und an dieses über die Verbindungsblattfedern angreifen. In bzw. entgegen der ersten Linearrichtung erstrecken sich ausgehend von dem zentralen Abschnitt übergangslos die beiden Endabschnitte, die beispielsweise eine Erstreckung in zweiter Linearrichtung aufweisen, die im Vergleich zur zweiten Gesamterstreckung des Umgebungsteils verkleinert ist, z.B. um mindestens den Faktor 2. Bezogen auf die zweite Linearrichtung kann das Umgebungsteil mit seinen beiden Endabschnitten spiegelsymmetrisch ausgebildet sein.

Nach einer Ausführungsform weist das Umgebungsteil in erster Linearrichtung eine erste Gesamterstreckung auf, die größer ist als seine zweite Gesamterstreckung in zweiter Linearrichtung. Diese Geometrie begünstigt es, die Vertikalblattfedern an geeigneter Stelle weiter vom Zentrum des Zentralteils zu beabstanden als die Verbindungsblattfedern, was weiter unten noch näher ausgeführt ist. Somit kann eine Verschwenkung/Rotation um die zweite Linearrichtung (als Rotationsachse), die aufgrund von Beschleunigungen entlang der ersten Linearrichtung (hervorgerufen durch eine entsprechende Bewegung des ersten Laufwagens) entstehen könnten, gedämpft bzw. in Gänze vermieden werden.

Die im Vergleich zur zweiten Gesamterstreckung in zweiter Linearrichtung längere erste Gesamterstreckung in erster Linearrichtung wird z.B. durch die beiden angrenzenden Endabschnitte des Umgebungsteils erzielt. Diese können darüber hinaus, wie soeben ausgeführt, in zweiter Linearrichtung im Vergleich zum zentralen Abschnitt verjüngt sein.

Beispielsweise ist die erste Gesamterstreckung des Kopplungsglieds in erster Linearrichtung mindestens 1,5 mal so lang wie die zweite Gesamterstreckung in zweiter Linearrichtung. Die erste Gesamterstreckung kann sogar mindestens doppelt so lang sein wie die zweite Gesamterstreckung.

Durch die Mehrzahl der Verbindungsblattfedern, die den Abstand zwischen dem zentralen Teil und dem Umgebungsteil ausbilden und diese beiden Teile des Kopplungsglieds miteinander verbinden, wird eine Verschwenkung um die dritte Linearrichtung (als Rotationsachse) bis zu einem gewissen Grad ermöglicht. Inwieweit eine Verschwenkung um diese Achse möglich ist, kann durch eine entsprechende Dimensionierung der Verbindungsblattfedern bestimmt werden.

Es liegt weiter im Rahmen der vorliegenden Erfindung, dass die beiden Endabschnitte des Umgebungsteils bezogen auf das Zentralteil um die dritte Linearrichtung (als Rotationsachse) schwenkbar angeordnet sind. Dies ist beispielsweise dadurch bewerkstelligt, dass an jedem der beiden Endabschnittes des Umgebungsteils die parallel zur ersten Linearrichtung angeordnete Vertikalblattfeder vorgesehen ist.

Die Vertikalblattfedern erstrecken sich z.B. von einer Oberseite des Kopplungsglieds zu einer Unterseite des Kopplungsglieds und gehen an der Unterseite in einen jeweiligen stegartigen Aufsatz über, der einen jeweiligen Teil der Montagefläche an der Unterseite ausbildet, der von dem übrigen Teil der Unterseite des Kopplungsglieds abgeschnitten ist, und der sich beispielsweise - wie die Unterseite - in einer Ebene erstreckt, die parallel zur ersten und zur zweiten Linearrichtung liegt.

Jede der Verbindungsblattfedern ist gemäß einer Ausführungsform in einer Ebene parallel zur dritten Linearrichtung angeordnet. Mit anderen Worten liegt jede Normale der Verbindungsblattfedern senkrecht zur dritten Linearrichtung. Gleiches gilt für die Vertikalblattfedern.

Gemäß einer Ausführungsform sind die Verbindungsblattfedern sternförmig zueinander angeordnet, derart, dass sich die Ebenen, in denen die Verbindungsblattfedern angeordnet sind, in einem Zentrum des Zentralteils schneiden. Dies ist beispielsweise dadurch bewerkstelligt, dass jede der Ebenen, in denen die Verbindungsblattfedern angeordnet sind, in einem Winkel, bezogen auf die erste Linearrichtung, von entweder betragsmäßig 45° oder 90° liegt, sodass insbesondere keine der Verbindungsblattfedern in einer Ebene parallel zur ersten Linearrichtung angeordnet ist. In diesen Ebenen parallel zur ersten Linearrichtung sind jedoch die Vertikalblattfedern angeordnet. Auch die Ebenen, in denen die Vertikalblattfedern angeordnet sind, schneiden sich also in dem Zentrum des Zentralteils.

Die Verbindungsblattfedern sind gemäß einer Ausführungsform in einem jeweiligen Mindestabstand zueinander angeordnet, beispielsweise von, bezogen auf die das Zentrum durchquerende und parallel zur dritten Linearrichtung befindliche Rotationsachse, mindestens 45°.

Die Verbindungsblattfedern als auch die Vertikalblattfedern sind gemäß einer Ausfiihrungsform jeweils als eine Einzelblattfeder ausgebildet.

Die Verbindungsblattfedern und die Vertikalblattfedern sind für eine Verschwenkung des Umgebungsteils um eine das Zentrum des Zentralteils durchquerende und parallel zur dritten Linearrichtung befindliche Rotationsachse ausgestaltet. Dazu schneiden sich die Ebenen, in denen die Vertikalblattfedern angeordnet sind, in dem Zentrum des Zentralteils. In wieweit eine Verschwenkung zugelassen werden soll, kann durch entsprechende Dimensionierung der Blattfedern bestimmt werden. Wenn vorliegend von einem Abstand zu dem Zentrum des Zentralteils die Rede ist, so ist damit ein parallel zu einer Ebene liegender Abstand gemeint, die durch die erste und zweite Linearrichtung definiert ist. Der besagte Abstand kann also insbesondere ein Abstand zu der das Zentrum des Zentralteils durchquerenden und parallel zur dritten Linearrichtung befindlichen Rotationsachse sein.

Durch die zueinander beabstandet angeordneten Verbindungsblattfedern entstehen Teilabschnitte in dem Volumen zwischen dem Zentralteil und dem Umgebungsteil. Gemäß einer Ausfiihrungsform sind diese Teilabschnitte als Leerräume ausgebildet, womit das Kopplungsglied ein geringes Gewicht aufweist.

Der Abstand zwischen dem Zentralteil und dem Umgebungsteil beträgt beispielsweise mindestens einige Millimeter, beispielsweise ca. 10 mm, und gemäß einer Ausführungsfonn 12,5 mm. Dieser Abstand kann in den beiden Linearrichtungen X und Y gleich sein. Entsprechend sind die diesen Abstand ausbildenden Verbindungsblattfedern dimensioniert. An dieser Stelle sei betont, dass die Verbindungsblattfedern nicht notwendigerweise eine entlang des Abstands gleichbleibende Dicke aufweisen müssen, sondern dass sich diese Dicken entlang des Abstands verändern kann. Auch müssen die Verbindungsblattfedern nicht allesamt gleichartig ausgebildet sein, sondern können - je nach gewünschter Steifigkeitseigenschaft des Kopplungsglieds - unterschiedliche Dicken aufweisen.

Nach einer weiteren Ausführungsform ist das Kopplungsglied derart ausgestaltet, dass eine Distanz entlang der ersten Linearrichtung zwischen den beiden Vertikalblattfedern größer ist als jeder Abstand zwischen zwei einander gegenüberliegenden Verbindungsblattfedern. Die Vertikalblattfedern sind in dieser Ausführungsform um mindestens den Faktor 2 weiter von dem Zentrum des Zentralteils entfernt als jede der Verbindungsblattfedern. Aufgrund dieser Anordnung mit einem jeweils vergleichsweise großen Abstand zum Zentrum des Zentralteils bewirken die beiden Vertikalblattfedern eine hohe Steifigkeit des Kopplungsglieds betreffend eine Verschwenkung/Rotation um die zweite Linearrichtung (als Rotationsachse).

Das Kopplungsglied ist gemäß einer Ausführungsform monolithisch ausgebildet, zum Beispiel aus einem Edelstahl. Somit sind sowohl das Umgebungsteil, das Zentralteil, als auch die diese Teile verbindenden Verbindungsblattfedern gemäß einer Ausführungsform aus einem Materialstück, z.B. einem Edelstahlstück, gefertigt.

Beispielsweise ist eine Montagefläche an der Oberseite des Kopplungsglieds für eine Ankopplung an die zweite Linearführung ausgestaltet, wobei es möglich ist, dass ausschließlich das Umgebungsteil, nicht aber das Zentralteil an der zweiten Linearführung befestigt ist.

Eine Montagefläche an der Unterseite des Kopplungsglieds kann für eine Ankopplung an den ersten Laufwagen ausgestaltet sein, wobei beispielsweise sowohl das Zentralteil als auch das Umgebungsteil an der zweiten Linearführung (beispielsweise über besagtes Aufnahmeglied) befestigt sind. Insbesondere können die stegartigen Aufsätze einen jeweiligen Teil der Montagefläche an der Unterseite ausbilden und an dem Aufnahmeglied und somit an dem ersten Laufwagen befestigt sein. Somit wird eine Rotation/Verschwenkung um die dritte Linearrichtung (als Rotationsachse) zu einem gewissen Grad begünstigt.

Gemäß einer Ausfuhrungsform erstrecken sich die Oberseite und die Unterseite jeweils parallel zur sowohl der ersten als auch der zweiten Linearrichtung.

Gemäß einer Ausführungsform ist der Abstand zwischen dem Zentralteil und dem Umgebungsteil entlang der ersten Linearrichtung größer als der Abstand zwischen diesen beiden Teilen in zweiter Linearrichtung.

Die Positioniereinrichtung kann, wie gesagt, in Portalbauweise ausgebildet sein. Hier sind verschiedenste Implementierungen denkbar. Beispielsweise kann die Positioniereinrichtung zwei erste Linearführungen aufweisen, die parallel zueinander angeordnet sind, und die beide einen jeweiligen ersten Laufwagen führen, und an beiden ersten Laufwagen kann ein jeweiliges Kopplungsglied entsprechend einer der oben beschriebenen Ausführungsformen angeordnet sein und eine Kopplung zur zweiten Linearführung ausbilden.

Nach einer anderen Ausführungsfonn umfasst die Positioniereinrichtung zwei (oder mehr als zwei) äußere Linearführungen, die benachbart und parallel zur ersten Linearführung angeordnet sind und jeweils mindestens einen Hilfswagen entlang die ersten Linearrichtung führen, wobei die zweite Linearführung (über das Kopplungsglied) an den ersten Laufwagen gekoppelt ist, und auch an die beiden Hilfswagen. Zur Ausbildung der Kopplung zwischen der zweiten Linearführung und den beiden Hilfswagen kann an jedem der beiden Hilfswagen eine jeweilige Kopplungsblattfeder befestigt sein, die in einer Ebene parallel zur ersten Linearrichtung und zur dritten Linearrichtung angeordnet ist. Auch diese Kopplungsblattfedern lassen eine Verschwenkung/Rotation um die dritte Linearrichtung (als Rotationsachse) in einem gewissen Grad zu, unterbinden jedoch eine Verschwenkung/Rotation um die erste Linearrichtung (als Rotationsachse) als auch um die zweite Linearrichtung (als Rotationsachse).

Vorgeschlagen werden vorliegend nicht nur das Kopplungsglied sowie die mit dem Kopplungsglied ausgestattete Positioniereinrichtung, sondern auch ein Verfahren zur Fertigung eines Kopplungsglieds. Das Verfahren umfasst: Fertigen, aus einem Stück, eines Zentralteils; eines in einem Abstand zu dem Zentralteil angeordneten und das Zentralteil umgebenden Umgebungsteils, wobei das Umgebungsteil einen zentralen, das Zentralteil umgebenen Abschnitt sowie zwei, in erster Linearrichtung an den zentralen Abschnitt angrenzende Endabschnitte aufweist; einer Mehrzahl von den Abstand ausbildenden Verbindungsblattfedern, die das Zentralteil und den zentralen Abschnitt des Umgebungsteil miteinander verbinden, wobei sich die Ebenen, in denen die Verbindungsblattfedern angeordnet sind, in einem Zentrum des Zentralteils schneiden; und, an jedem der beiden Endabschnitte des Umgebungsteils, einer parallel zur ersten Linearrichtung angeordneten Vertikalblattfeder.

Beispielhafte Ausfiihrungsformen des Verfahrens zur Fertigung des Kopplungsglieds entsprechen den oben beschriebenen Ausfiihrungsformen des Kopplungsglieds bzw. den oben beschriebenen Ausführungsformen der Positioniereinrichtung, sodass auf das Vorstehende verwiesen wird.

Das Fertigen umfasst beispielsweise mehrere Verarbeitungsschritte, wie einen Stanzschritt, einen Frässchritt und dergleichen. Um das Kopplungsglied für die Ausbildung der Kopplung zwischen dem ersten Laufwagen und der zweiten Linearführung auszugestalten, umfasst das Verfahren beispielsweise weiterhin ein Formen von Aussparungen in dem Umgebungsteil und in dem Zentralteil, in die zur Ausbildung besagter Kopplung seitens der zweiten Linearführung und seitens des ersten Hilfswagens Befestigungselemente eingreifen können.

Weitere Einzelheiten und Vorteile der Erfindung werden bei der nachfolgenden Beschreibung einiger Ausführungsbeispiele anhand der Figuren deutlich werden.

Es zeigen:
- Fig. 1: exemplarisch und schematisch einen Ausschnitt einer Aufsicht auf eine Positioniereinrichtung gemäß einer oder mehreren Ausführungsformen;
- Fig. 2: exemplarisch und schematisch einen Ausschnitt einer perspektivischen Ansicht eines Kopplungsglieds gemäß einer oder mehreren Ausführungsformen;
- Fig. 3A-B: jeweils exemplarisch und schematisch einen Ausschnitt einer perspektivischen Ansicht eines Kopplungsglieds gemäß einer oder mehreren Ausführungsformen;
- Fig. 4: exemplarisch und schematisch einen Ausschnitt einer perspektivischen Ansicht eines Aufnahmeglieds gemäß einer oder mehreren Ausführungsformen;
- Fig. 5A: exemplarisch und schematisch einen Ausschnitt einer perspektivischen Ansicht einer Positioniereinrichtung gemäß einer oder mehreren Ausführungsformen;
- Fig. 5B-C: jeweils exemplarisch und schematisch einen Ausschnitt einer Querschnittsansicht einer Positioniereinrichtung gemäß einer oder mehreren Ausführungsformen; und
- Fig. 6: exemplarisch und schematisch einen Ausschnitt einer perspektivischen Ansicht eines Hilfswagens gemäß einer oder mehreren Ausführungsformen.

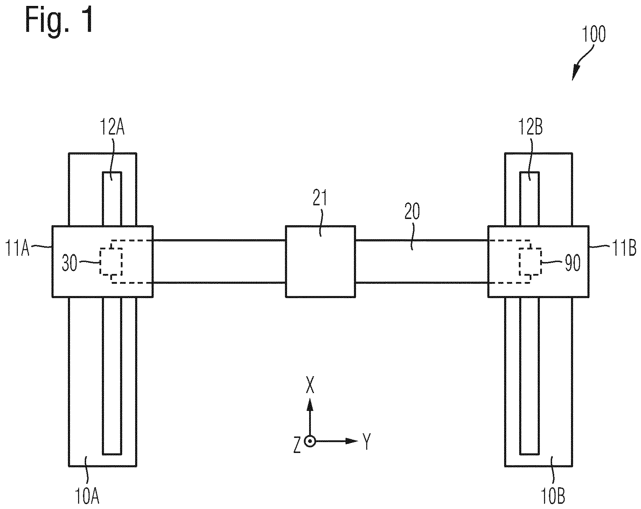

Figur 1 zeigt schematisch und exemplarisch eine Positioniereinrichtung 100. Die Positioniereinrichtung 100 ist in Portalbauweise ausgebildet und umfasst zwei erste Linearführungen 10A und 10B.

Die beiden ersten Linearführungen 10A und 10B führen einen jeweiligen ersten Laufwagen 11A bzw. 11B entlang einer ersten Linearrichtung X. Für diese Führung kann eine jeweilige Führungsschiene oder Führungsnut oder sonstiges Führungsmittel 12A bzw. 12B vorgesehen sein.

Die Positioniereinrichtung 100 umfasst weiter eine zweite Linearführung 20, die einen zweiten Laufwagen 21 entlang einer zweiten, zur ersten Linearrichtung X im Wesentlichen senkrechten Linearrichtung Y führt.

Die zweite Linearführung 20 ist an die beiden ersten Laufwagen 11A, 11B gekoppelt und somit entlang der ersten Linearrichtung X beweglich. Zur Bewirkung der Bewegung in erster und zweiter Linearrichtung X und Y sind entsprechende Elektroantriebe vorgesehen.

Die zweite Linearführung 20 ist somit z.B. als Querbalken ausgebildet, der oberhalb (bezogen auf eine dritte Linearrichtung Z, die senkrecht zur ersten und zur zweiten Linearrichtung X, Y liegt) der ersten Linearführungen 10A, 10B angeordnet ist.

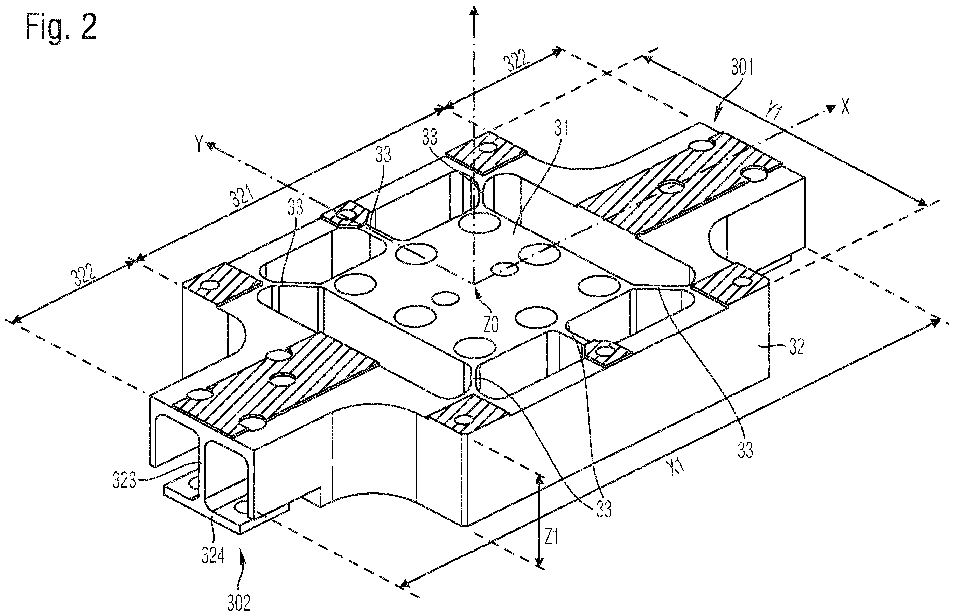

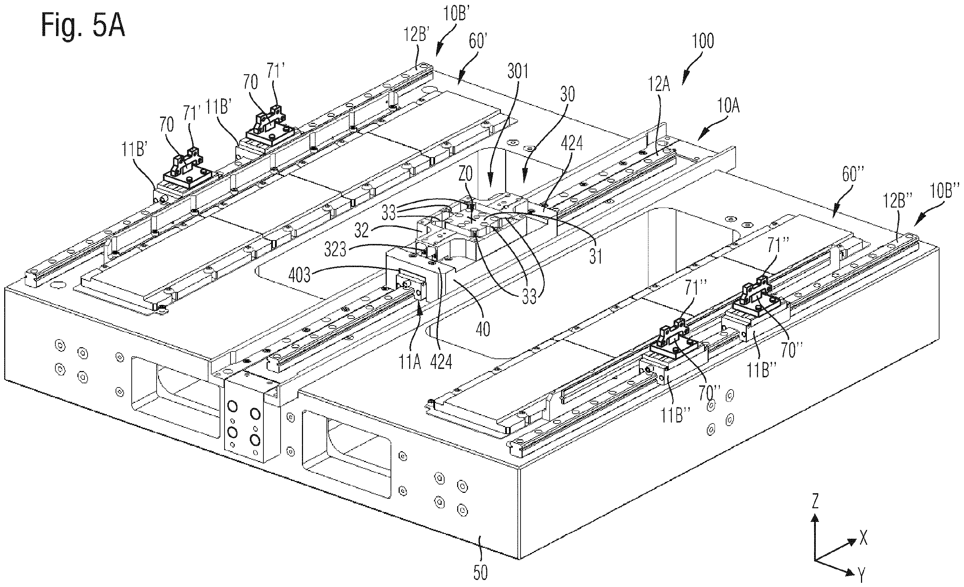

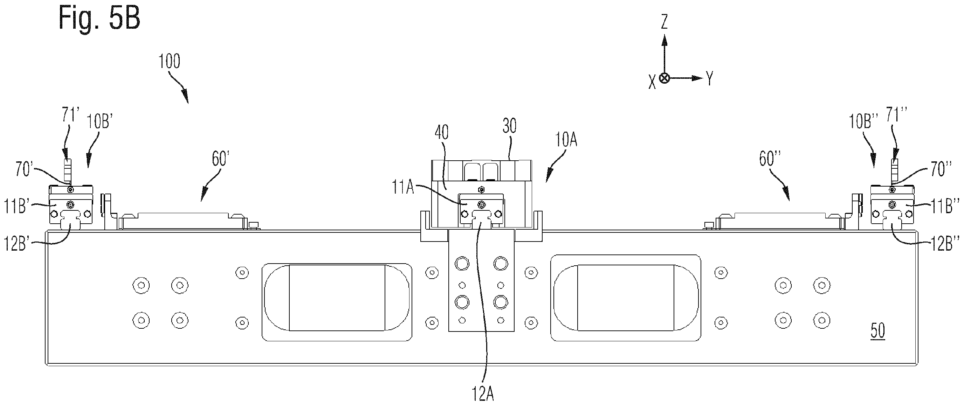

Zur Ausbildung der Kopplung zwischen der zweiten Linearführung 20 und dem ersten Laufwagen 11A ist ein in der Figur 2 dargestelltes Kopplungsglied 30 vorgesehen. In den Figuren 5A-C ist die Anordnung des Kopplungsglieds 30 in einer anderen Ausführungsform der Positioniereinrichtung 100 schematisch und exemplarisch dargestellt, und im Folgenden wird auch auf diese Figuren 5A-C C Bezug genommen.

Das Kopplungsglied 30 hat eine Oberseite 301 und eine Unterseite 302. Die Oberseite 301 ist an der zweiten Linearführung 20 befestigt, und die Unterseite 302 an dem ersten Laufwagen 11A.

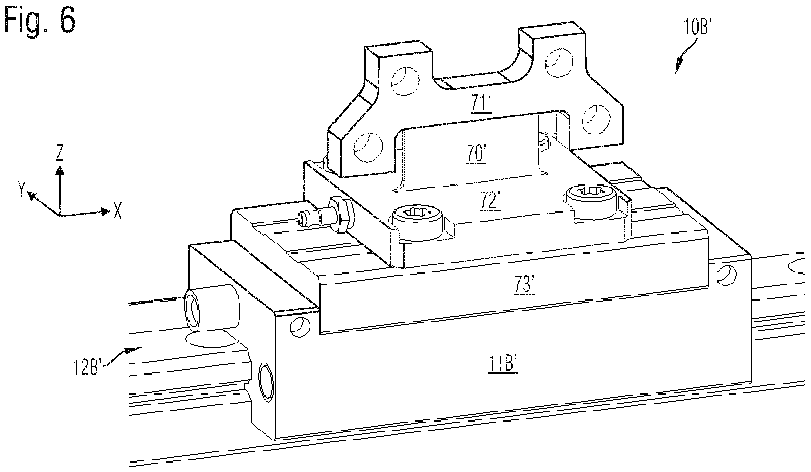

Im Folgenden wird stets Bezug genommen auf diesen ersten Laufwagen 11A, wobei gemäß anderen Ausführungsformen ein weiteres Kopplungsglied 90 vorgesehen sein kann, das die Kopplung zwischen der zweiten Linearführung 20 und dem weiteren Laufwagen 11B, der in ersten Linearrichtung X geführt wird, herstellt, wie in Fig. 1 schematisch dargestellt. Dieses weitere Kopplungslied 90 kann insbesondere als Kopplungsblattfeder ausgestaltet sein (also anders als das Kopplungsglied 30), was mit Bezug auf die Fig. 5A-C und Fig. 6 näher ausgeführt ist.

Das Kopplungsteil weist ein Zentralteil 31 auf, welches von einem Umgebungsteil 32 umgeben ist. Das Umgebungsteil 32 ist in einem Abstand zu dem Zentralteil 31 angeordnet. Eine Mehrzahl von diesen Abstand ausbildenden Verbindungsblattfedern 33 verbinden das Zentralteil 31 und das Umgebungsteil 32 miteinander.

Das Kopplungsglied 30 ist derart ausgestaltet, dass es eine Verschwenkung/Rotation um die dritte Linearrichtung Z (als Rotationsachse durch das Zentrum Z0 des Zentralteils 31) bis zu einem gewissen Grad ermöglicht, jedoch die Rotation um die erste Linearrichtung X (als Rotationsachse) und insbesondere um die zweite Linearrichtung Y (als Rotationsachse) weitgehend vermeidet oder gar vollständig unterbindet.

Das Umgebungsteil 32 weist eine erste Gesamterstreckung X1 in erster Linearrichtung X auf und eine zweite Gesamterstreckung Y1 in zweiter Linearrichtung Y, wobei die zweite Gesamterstreckung Y1 kleiner sein kann als die erste Gesamterstreckung X1. Zum Beispiel ist die erste Gesamterstreckung X1 mindestens 1,5-mal so lang wie die zweite Gesamterstreckung Y1, oder sogar mindestens zweimal so lang.

Wie in der Figur 2 dargestellt, ist das Umgebungsteil 32 in einen zentralen, das Zentralteil 31 umgebenden Abschnitt 321 sowie in zwei, in erster Linearrichtung X an den zentralen Abschnitt 321 angrenzende Endabschnitte der 322 unterteilt. Insbesondere mittels dieser Endabschnitte 322 wird die im Vergleich zur zweiten Gesamterstreckung Y1 längere erste Gesamterstreckung X1 erzielt.

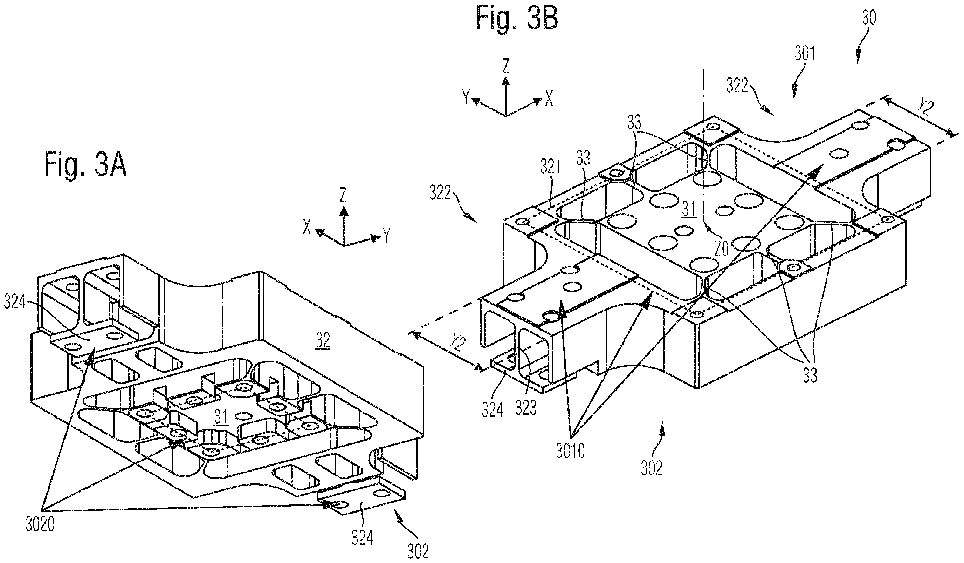

Die zweite Gesamterstreckung Y1 des Umgebungsteils 32 ist definiert durch die Gesamterstreckung des zentralen Abschnitts 321 in zweiter Linearrichtung Y. Die beiden Endabschnitte 322 können im Vergleich zu dieser zweiten Gesamterstreckung Y1 verjüngt sein und einer (vergleiche Figur 3B) kürzere Erstreckung Y2 aufweisen. Auf diesen Aspekt der Ausgestaltung des Kopplungsglieds 30 wird an späterer Stelle noch weiter eingegangen werden.

Das Kopplungsglied 30 kann monolithisch ausgestaltet sein, und beispielsweise aus einem Edelstahl gefertigt sein. Somit sind insbesondere das Zentralteil 31, das Umgebungsteil 32 sowie die Verbindungsblattfedern 33 aus einem Stück gefertigt. Die beiden Endabschnitte 322 grenzen damit übergangslos an den zentralen Abschnitt 321 an.

Wohingegen eine Verschwenkung/Rotation um die zweite Linearrichtung Y (als Rotationsachse) - wie ausgeführt - unerwünscht ist, kann eine Verschwenkung/Rotation um die dritte Linearrichtung Z (als Rotationsachse) bis zu einem gewissen Grad erwünscht sein. Dazu ist jede der Verbindungsblattfedern 33 in einer Ebene parallel zu der dritten Linearrichtung Z angeordnet. Die Verbindungsblattfedern 33 sind, wie dargestellt, sternförmig zueinander angeordnet, beispielsweise indem jede der Ebenen, in denen die Verbindungsblattfedern 33 angeordnet sind, in einem Winkel, bezogen auf die erste Linearrichtung X, von entweder betragsmäßig 45° oder 90° liegt. Die Ebenen, in denen die Verbindungsblattfedern 33 angeordnet sind, schneiden sich in einem Zentrum Z0 des Zentralteils 31. Eine parallel zur dritten Linearrichtung Z liegende und dieses Zentrum Z0 des Zentralteils 31 durchquerende Achse bildet die Rotationsachse (bezogen auf eine Rotation um die dritte Linearrichtung Z) des Kopplungsglieds 30.

Bei den in den Zeichnungen dargestellten Ausführungsbeispielen sind insgesamt sechs Verbindungsblattfedern 33 vorgesehen, die sich in einem Winkel von betragsmäßig 45° bzw. 90° zur ersten Linearrichtung X erstrecken, um das Zentralteil 31 mit dem Umgebungsteil 32 zu verbinden. Dahingegen sind zwischen dem Zentralteil 31 und dem Umgebungsteil 32 keine Verbindungsblattfedern vorgesehen, die sich parallel zur ersten Linearrichtung X erstrecken würden. Vielmehr sind statt solcher an den Endabschnitten 322 Vertikalblattfedern 323 vorgesehen, die sich von der Oberseite 301 entlang der dritten Linearrichtung Z zur Unterseite 302 erstrecken und dort in einen jeweiligen stegartigen Aufsatz 324 übergehen. Der Abstand zwischen diesen beiden Vertikalblattfedern 323 ist somit deutlich größer als der Abstand zwischen zwei einander gegenüberliegen (also um 180° versetzten) Verbindungsblattfedern 33.

Auch die Ebenen, in denen die Vertikalblattfedern 323 angeordnet sind, schneiden sich in dem Zentrum Z0 des Zentralteils 31.

Die Verbindungsblattfedern 33 und die Vertikalblattfedern 323 sind für eine Verschwenkung des Umgebungsteils 32 um die das Zentrum Z0 des Zentralteils 31 durchquerende und parallel zur dritten Linearrichtung Z befindliche Rotationsachse - also kurz: für eine Verschwenkung des Umgebungsteils 32 um die dritte Linearrichtung Z (als Rotationsachse) - ausgestaltet. Gleichzeitig ist die Distanz entlang der ersten Linearrichtung X zwischen den beiden Vertikalblattfedern 323 größer als jeder Abstand zwischen zwei einander gegenüberliegenden Verbindungsblattfedern 33. Insbesondere sind die Vertikalblattfedern 323 weiter von dem Zentrum Z0 des Zentralteils 31 entfernt als jede der Verbindungsblattfedern 33.

Beispielsweise ist jede der Vertikalblattfedern 323 mindestens 1,5 mal oder mindestens 2 mal soweit von dem Zentrum Z0 des Zentralteils 31 entfernt wie jede der Verbindungsblattfedern 33. Dabei können alle Verbindungsblattfedern 33 gleich weit vom Zentrum Z0 des Zentralteils 31 entfernt sein.

Die Blattfedern 33 sowie 323 sind somit derart ausgestaltet, dass eine Verschwenkung/Rotation um die zweite Linearrichtung Y (als Rotationsachse) weitgehend vermieden bzw. vollständig unterbunden wird, wohingegen eine Verschwenkung/Rotation um die dritte Linearrichtung Z (als Rotationsachse) bis zu einem gewissen Grad möglich ist. Inwieweit eine Verschwenkung/Rotation um diese Achse ermöglicht wird, kann durch eine entsprechende Dimensionierung der Blattfedern 33 und 323 bestimmt werden.

Im Übrigen ist das Kopplungsglied 30 insbesondere aufgrund der Ausgestaltung und Anordnung der Verbindungsblattfedern 33 derart ausgebildet, dass auch eine Verschwenkung/Rotation um die erste Linearrichtung X (als Rotationsachse) weitgehend vermieden bzw. vollständig unterbunden wird. Allerdings sind die Belastungen betreffend eine Verschwenkung/Rotation um die zweite Linearrichtung Y (als Rotationsachse) aufgrund der parallel zur ersten Linearrichtung X wirkenden starken Beschleunigungskräfte sowie aufgrund der Anordnung der zweiten Linearführung 20 oberhalb der ersten Linearführungen 10A, 10B' und 10B" vergleichsweise hoch, und damit eine höhere Steifigkeit betreffend eine Verschwenkung/Rotation um eben diese die zweite Linearrichtung Y (als Rotationsachse) erwünscht. Insbesondere kann gemäß einer Ausfiihrungsform des Kopplungsglieds 30 die Steifigkeit betreffend eine Verschwenkung/Rotation um die zweite Linearrichtung Y (als Rotationsachse) größer sein als die Steifigkeit betreffend eine Verschwenkung/Rotation um die erste Linearrichtung X (als Rotationsachse).

Die Verbindungsblattfedern 33 begrenzen, wie dargestellt Teilabschnitte des Volumens zwischen dem Zentralteil 31 und dem Umgebungsteil 32. Diese Teilabschnitte sind als Leerräume ausgebildet, und ermöglichen somit ebenfalls eine Verschwenkung/Rotation um die dritte Linearrichtung Z (als Rotationsachse).

Die beiden Endabschnitte 322 des Umgebungsteils 32 können, bezogen auf das Zentralteil 31, um die dritte Linearrichtung Z (als Rotationsachse) schwenkbar angeordnet sein. Zum Beispiel sind die stegartigen Aufsätze 324, wie dargestellt, von dem übrigen Teil der Unterseite 302 sowie ebenfalls von einer Seitenwand, die sich von der Oberseite 301 zur Unterseite 102 erstreckt, abgeschnitten.

Je nach gewünschter Steifigkeit des Kopplungsglieds 30 können die Dicken der Blattfedern 33 und 323 dimensioniert werden. Zum Beispiel liegt es im Rahmen der vorliegenden Erfindung, dass die Dicken der Verbindungsblattfedern 33 voneinander abweichen und/oder, dass die Dicke einer jeweiligen der Verbindungsblattfedern 33 entlang des Abstands zwischen dem Zentralteil 31 und dem Umgebungsteil 32 variiert.

Mit Bezug auf die Figuren 3A, 3B, 4 sowie 5A-C wird nachstehend etwas näher auf eine beispielhafte Installation des Kopplungsglieds 30 in der Positioniereinrichtung 100 eingegangen.

Das Kopplungsglied 30 hat eine Oberseite 301 und eine Unterseite 302, und ist beispielsweise derart in der Positioniereinrichtung 100 angeordnet, dass eine Montagefläche 3020 an der Unterseite 302 des Kopplungsglieds 30 am ersten Laufwagen 11A befestigt ist, und dass eine Montagefläche 3010 an der Oberseite 301 an der zweiten Linearführung 20 befestigt ist.

Insbesondere kann vorgesehen sein, dass zur Herstellung der Kopplung zwischen der zweiten Linearführung 20 und dem Kopplungsglied 30 das Kopplungsglied 30 nur mittels des Umgebungsteils 32 an der zweiten Linearführung 20 befestigt ist, nicht aber über das Zentralteil 31. In der Figur 2 und Figur 3B ist die entsprechende Montagefläche 3010 des Umgebungsteils 32, die an der zweiten Linearführung 20 befestigt ist, durch entsprechend schraffierten Gebiete hervorgehoben bzw. durch die geradlinigen Pfeile markiert. Beispielsweise weist das Kopplungsglied 30 dafür an den betreffenden Stellen Aussparungen auf, in die Befestigungsstifte oder andere Befestigungsmittel eingreifen können.

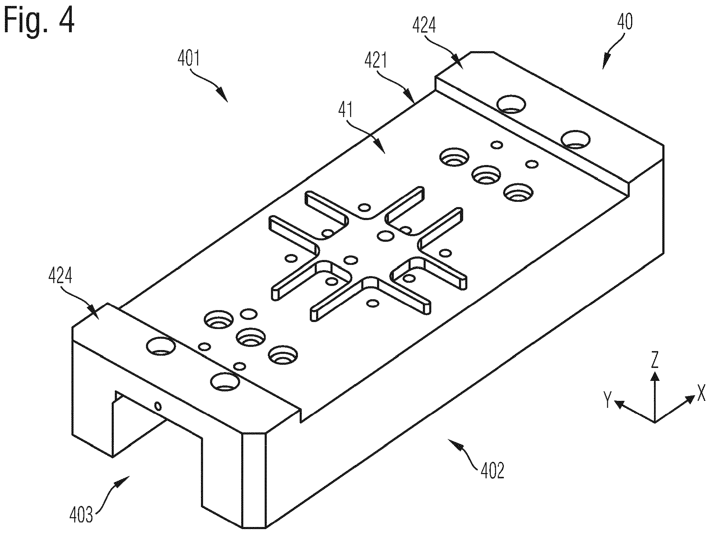

Die Positioniereinrichtung 100 umfasst weiter ein in Figur 4 näher dargestelltes Aufnahmeglied 40, dass an dem ersten Laufwagen 11A befestigt ist und für eine Ausbildung einer Kopplung mit dem Kopplungsglied 30 ausgebildet ist. Beispielsweise koppelt die Montagefläche 3020 an der Unterseite 302 des Kopplungsglieds 30 am ersten Laufwagen 11A an, z.B. derart, dass sowohl das Zentralteil 31 als auch das Umgebungsteil 32 an dem Aufnahmeglied 40 befestigt sind. In der Figur 3A ist die entsprechende Montagefläche 3020 des Kopplungsglieds 30 durch die drei geradlinigen Pfeile markiert.

Eine Oberseite 401 des Aufnahmemitglieds 40 ist an die Geometrie des Kopplungsglieds 30, insbesondere an die Montagefläche 3020 an der Unterseite 302 des Kopplungsglieds 30 angepasst. Das Umgebungsteil 32 greift beispielsweise mittels des zentralen Abschnitts 321 als auch mittels der stegartigen Aufsätze 324 an entsprechend ausgebildeten Abschnitten 41 und 421 des Aufnahmegliedes 40 an. Die stegartigen Aufsätze 324 bilden somit einen jeweiligen Teil der Montagefläche 3020 an der Unterseite 302 aus und erstrecken sich beispielsweise genauso tief wie der übrige Teil der Unterseite 302 des Kopplungsglieds 30, so dass die entsprechenden Abschnitte 421 an der Oberseite 401 des Aufnahmeglieds 40 an die stufenartigen Hervorhebungen 424 der Oberseite 401 angrenzend ausgebildet sind. Etwas tiefer eingelassen in das Aufnahmeglied 40 ist somit gemäß der beispielhaften Ausführungsform die gesamte Unterseite 302 des Kopplungsglieds 30, einschließlich der Endabschnitte 322 und des zentralen Abschnitts 321 des Umgebungsteils 32 (an Abschnitten 421) sowie des Zentralteils 31 (am Abschnitt 41). Für das Zentralteil 31 ist bei dem Aufnahmeglied 40 der dem Zentralteil 31 strukturmäßig entsprechend ausgebildete Abschnitt 41 vorgesehen, der z.B. eine in etwa #-förmige Struktur aufweist.

Die Länge in erster Linearrichtung X des eingelassenen und durch die stufenartigen Hervorhebungen begrenzten Abschnitt der Oberseite 401 des Aufnahmeteils 40 beträgt z.B. exakt der ersten Gesamterstreckung X1, sodass das an der Oberseite 401 befestigte Kopplungslied 30 durch die stufenartigen Hervorhebungen 424 in erster Linearrichtung X stabilisiert ist, wie in Fig. 5A veranschaulicht ist.

Durch das bezogen auf die dritte Linearrichtung Z gestufte Profil der Oberseite 401 des Aufnahmeglieds 40 wird eine erhöhte Stabilität bezogen auf die erste Linearrichtung X erzielt. Der zentrale Abschnitt 321 des Umgebungsteils 32 sowie der Zentralteil 31 des Kopplungsglieds sind somit in das Aufnahmeglied 40 eingelassen, wohingegen die beiden Endabschnitte 322 auf den stufenartigen Hervorhebungen 424 aufliegen.

An der Unterseite 402 des Aufnahmemitglieds 40 ist eine nutartige Aussparung 403 vorgesehen, in die der erste Laufwagen 11A eingreift, wie in den Figuren 5A-C dargestellt.

Gemäß dem in den Figuren 5A-C dargestellten Ausführungsbeispiel umfasst die Positioniereinrichtung 100 zwei äußere Linearführungen 10B' und 10B", die benachbart und parallel zur ersten Linearführung 10A angeordnet sind und jeweils mindestens einen (in den dargestellten Ausführungsbeispielen zwei) Hilfswagen 11B`, 11B" entlang der ersten Linearrichtung X führen. Die Führungen 10A, 10B' und 10B" sind an einer Basiskonstruktion 50 der Positioniereinrichtung 100 befestigt.

Die zweite Linearführung 20 ist sowohl an den ersten Laufwagen 11A als auch an die insgesamt vier Hilfswagen 11B`, 11B" gekoppelt und wird so entlang der ersten Linearrichtung X bewegt.

Die erste Linearführung 10A führt, wie gesagt, den ersten Laufwagen 11A entlang der ersten Linearrichtung X. Für diese Führung ist eine Schiene 12A vorgesehen.

Die beiden äußeren Linearführungen 10B' und 10B" sind in ähnlicher Weise ausgestaltet, und umfassen zur Führung der Hilfswagen 11B` und 11B" jeweils eine entsprechend angeordnete Schiene 12 B', 12 B".

Ebenfalls an der Basiskonstruktion 50 befestigt sind die magnetischen Pfade 60', 60" zweier Linearmotoren. Auf Einzelheiten dieser Komponenten soll hier nicht näher eingegangen werden. Dem Fachmann sind, beispielsweise aus der EP 0 793 870 B1, einige Varianten bekannt, wie ein magnetischer Pfad für eine Positioniereinrichtung der vorliegenden Gestalt ausgebildet werden kann.

Die zweite Linearführung 20 ist sowohl an den ersten Laufwagen 11A gekoppelt als auch an die vier Hilfswagen 11B' und 11B". Bei der dargestellten Ausführungsform wird die zweite Linearführung 20 durch entsprechende Bestromung der Linearmotoren entlang der ersten Linearrichtung X bewegt.

Zur Kopplung der zweiten Linearführung 20 an den ersten Hilfswagen 11A ist das Kopplungsglied 30 vorgesehen, das entsprechend den obigen Ausführungen ausgestaltet ist.

Zur Ausbildung der Kopplung zwischen der zweiten Linearführung 20 und den Hilfswagen 11B`, 11B" ist an jedem dieser Hilfswagen 11B`, 11B" eine jeweilige Kopplungsblattfeder 70`, 70"befestigt, die in einer Ebene parallel zur ersten Linearrichtung X und zur dritten Linearrichtung Z angeordnet ist.

Die Kopplungsblattfedern 70', 70" bilden die Kopplung zur zweiten Linearführung 20 aus. Dabei ist die Kopplung der Kopplungsblattfedern 70', 70" an die zweite Linearführung 20 derart ausgestaltet, dass eine Rotation/Verschwenkung der zweiten Linearführung 20 um die dritte Linearrichtung Z (als Rotationsachse) bis zu einem gewissen Grad ermöglicht ist, jedoch eine Verschwenkung/Rotation um die erste Linearrichtung X (als Rotationsachse) als auch um die zweite Linearrichtung Y (als Rotationsachse) vermieden wird.

Gemäß einer Ausführungsform der Positioniereinrichtung 100 ist zur Kopplung der zweiten Linearführung 20 an die erste Linearführung 10A sowie die Führungen 10B', 10B" nur ein einziges Kopplungsglied 30 vorgesehen. Die Kopplung der zweiten Linearführung 20 an die Hilfswagen 11B`, 11B" erfolgt über weitere Kopplungselemente, die nicht wie das Kopplungsglied 30 ausgestaltet sind, sondern in anderer Weise, beispielsweise als besagte Kopplungsblattfedern 70`, 70". Aufgrund der Kopplungsblattfedern 70', 70" kann die Positioniereinrichtung 100 z.B. eine thermisch bedingte Ausdehnung der zweiten Linearführung 20 tolerieren.

Eine beispielhafte Ausführungsform der Hilfswagen 11B`, 11B" ist in der Figur 6 veranschaulicht. Der Hilfswagen 11B` (die übrigen Hilfswagen sind in gleicher Weise ausgestaltet) ist mit zwei Aufsatzelementen 72` und 73` bestückt, und auf dem obersten Aufsatzelement 72` befindet sich die Kopplungsblattfeder 70`. Die Kopplungsblattfeder 70` geht über in ein weiteres Kopplungsmittel 71', das für eine Befestigung an der zweiten Linearführung 20 ausgestaltet ist.

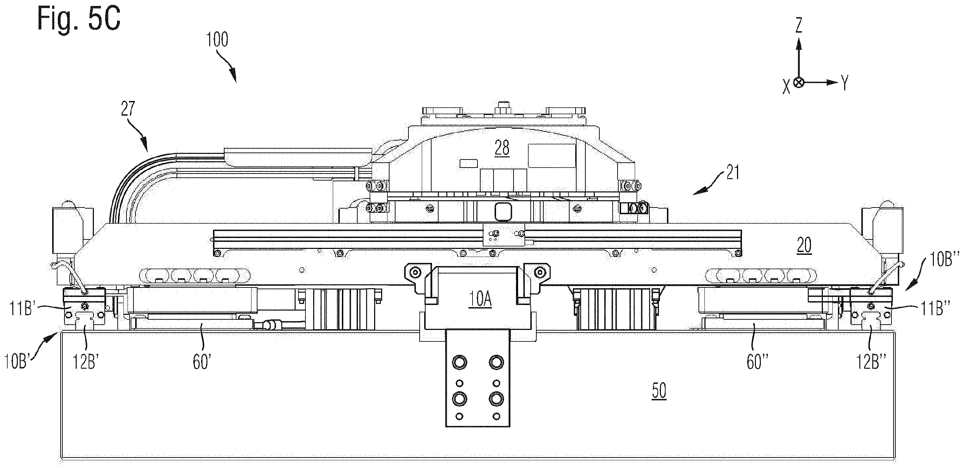

Bezugnehmend auf die Figur 5C führt die zweite Linearrichtung 20 den zweiten Laufwagen 21 entlang der zweiten Linearrichtung Y. Der zweite Laufwagen 21 ist mit einem Funktionselement 28 versehen, das beispielsweise über einen flexiblen Strang 27 angesprochen und gesteuert wird. Beispiele für verschiedene Funktionselemente sind bereits oben erwähnt worden, und es sei an dieser Stelle nochmals betont, dass die vorliegende Erfindung nicht auf ein bestimmtes Funktionselement bzw. ein bestimmtes Anwendungsgebiet der Positioniereinrichtung 100 beschränkt ist.

Vorgeschlagen werden vorliegend nicht nur das Kopplungsglied 30 sowie die mit dem Kopplungsglied ausgestattete Positioniereinrichtung 100, sondern auch ein Verfahren zur Fertigung eines Kopplungsglieds. Das Verfahren umfasst: Fertigen, aus einem Stück, eines Zentralteils; eines in einem Abstand zu dem Zentralteil angeordneten und das Zentralteil umgebenden Umgebungsteils mit einer ersten Gesamterstreckung in erster Linearrichtung und einer zweiten Gesamterstreckung in zweiter Linearrichtung, die kleiner ist als die erste Gesamterstreckung; und einer Mehrzahl von den Abstand ausbildenden Verbindungsblattfedern, die das Zentralteil und das Umgebungsteil miteinander verbinden. Das Verfahren umfasst weiter ein Ausgestalten des Kopplungsglieds für eine Ausbildung einer Kopplung zwischen dem ersten Laufwagen und der zweiten Linearführung.

Beispielhafte Ausführungsformen des Verfahrens zur Fertigung des Kopplungsglieds entsprechen den oben beschriebenen Ausführungsformen des Kopplungsglieds bzw. den oben beschriebenen Ausführungsformen der Positioniereinrichtung, sodass auf das Vorstehende verwiesen wird.

Das Fertigen umfasst beispielsweise mehrere Verarbeitungsschritte, beispielsweise einen Stanzschritt, einen Frässchritt und dergleichen. Um das Kopplungsglied für die Ausbildung der Kopplung zwischen dem ersten Laufwagen und der zweiten Linearführung auszugestalten, umfasst das Verfahren beispielsweise das Formen von Aussparungen in dem Umgebungsteil und in dem Zentralteil, in die zur Ausbildung besagter Kopplung beispielsweise Befestigungselemente eingreifen können.

Das hier beschriebene Kopplungsglied 30 weist aufgrund des seines geometrischen Designs eine hohe Steifigkeit betreffend translatorische Kräfte entlang der drei Linearrichtungen X, Y und Z auf sowie eine hohe Steifigkeit betreffend rotatorische Kräfte um die erste Linearrichtung X (als Rotationsachse) und insbesondere um die zweite Linearrichtung Y (als Rotationsachse). Mit Blick auf die rotatorische Kräfte um die dritte Linearrichtung Z (als Rotationsachse) weist das Kopplungsglied 30 eine Flexibilität auf, um eine Rotation/Verschwenkung um diese Achse bis zu einem gewissen Grad zuzulassen.

Das Kopplungsglied 30 erlaubt es, die Positioniereinrichtung 100 mit einem geringen Kippfehler (sog. Abbe Error) bereitzustellen. Dies kann weiter dadurch begünstigt werden, indem das Kopplungsglied 30 eine dritte Gesamterstreckung Z1 (s. Fig. 2) in dritter Linearrichtung Z aufweist, die deutlich geringer ist als sowohl die erste Gesamterstreckung X1 als auch als die zweite Gesamterstreckung Y1. Beispielsweise beträgt die dritte Gesamterstreckung Z1 nicht mehr als 50%, und nicht mehr als 30% der ersten Gesamterstreckung X1. Zum Beispiel beträgt die erste Gesamterstreckung X1 ca. 146 mm, die zweite Gesamterstreckung Y1 ca. 78 mm, und die dritte Gesamterstreckung Z1 ca. 21 mm.

Das Kopplungsglied 30 kann - wie ausgeführt - aus einem Edelstahl gefertigt sein, oder einem anderen Material, das ein hohes Elastizitätsmodul ("Young modulus") ermöglicht.

Das Aufnahmeglied 40 kann aus einem leichten Material, bspw. aus Aluminium gefertigt sein. Es stellt, wie ausgeführt, die mechanische Schnittstelle zwischen dem ersten Laufwagen 11A und Kopplungsglied 30 bereit.

## Patentansprüche

1. Kopplungsglied (30) für eine Positioniereinrichtung (100), umfassend :
- ein Zentralteil (31);
- ein in einem Abstand zu dem Zentralteil (31) angeordnetes und das Zentralteil (31) umgebendes Umgebungsteil (32), wobei das Umgebungsteil (32) einen zentralen, das Zentralteil (31) umgebenen Abschnitt (321) sowie zwei, in erster Linearrichtung (X) an den zentralen Abschnitt (321) angrenzende Endabschnitte (322) aufweist;
- **gekennzeichnet durch** eine Mehrzahl von den Abstand ausbildenden Verbindungsblattfedern (33), die das Zentralteil (31) und den zentralen Abschnitt des Umgebungsteil (32) miteinander verbinden, wobei sich die Ebenen, in denen die Verbindungsblattfedern (33) angeordnet sind, in einem Zentrum (Z0) des Zentralteils (31) schneiden; und
- an jedem der beiden Endabschnitte (322) des Umgebungsteils (32), eine parallel zur ersten Linearrichtung (X) angeordnete Vertikalblattfeder (323) vorgesehen ist, wobei sich auch die Ebenen, in denen die Vertikalblattfedern (323) angeordnet sind, in dem Zentrum (Z0) des Zentralteils (31) schneiden, so dass die Verbindungsblattfedern (33) und die Vertikalblattfedern (323) für eine Verschwenkung des Umgebungsteils (32) um eine das Zentrum (Z0) des Zentralteils (31) durchquerende und parallel zu einer dritten Linearrichtung (Z) befindliche Rotationsachse ausgestaltet sind.

2. Kopplungsglied (30) nach Anspruch 1, wobei jede der Verbindungsblattfedern (33) in einer Ebene parallel zu der dritten Linearrichtung (Z) angeordnet ist, wobei die dritte Linearrichtung (Z) senkrecht zur sowohl der ersten Linearrichtung (X) als auch zu einer zweiten, zur ersten Linearrichtung (X) senkrechten Linearrichtung (Y) ist.

3. Kopplungsglied (30) nach einem der vorstehenden Ansprüche, wobei
- eine Montagefläche (3010) an einer Oberseite (301) des Kopplungsglieds (30) vorgesehen ist;
- eine Montagefläche (3020) an einer Unterseite (302) des Kopplungsglieds (30) vorgesehen ist.

4. Kopplungsglied (30) nach Anspruch 3, wobei sich die Vertikalblattfedern (323) jeweils von der Oberseite (301) zur Unterseite (302) erstrecken und an der Unterseite (302) in einen jeweiligen stegartigen Aufsatz (324) übergehen, der einen jeweiligen Teil der Montagefläche (3020) an der Unterseite (302) ausbildet.

5. Kopplungsglied (30) nach einem der vorstehenden Ansprüche, wobei die Vertikalblattfedern (323) um mindestens den Faktor 2 weiter von dem Zentrum (Z0) des Zentralteils (31) entfernt sind als jede der Verbindungsblattfedern (33).

6. Kopplungsglied (30) nach einem der vorstehenden Ansprüche, wobei das Kopplungsglied (30) monolithisch ausgebildet ist.

7. Positioniereinrichtung (100), umfassend
- eine erste Linearführung (10A) zur Führung eines ersten Laufwagens (11A) entlang einer ersten Linearrichtung (X);
- eine zweite Linearführung (20) zur Führung eines zweiten Laufwagens (21) entlang einer zweiten, zur ersten Linearrichtung (X) senkrechten Linearrichtung (Y); und
- ein Kopplungsglied (30) gemäß einem der Ansprüche 1 bis 6, das für eine Ausbildung einer Kopplung zwischen dem ersten Laufwagen (11A) und der zweiten Linearführung (20) ausgestaltet ist.

8. Positioniereinrichtung (100) nach Anspruch 7, weiter umfassend ein Aufnahmeglied (40), das am ersten Laufwagen (11A) befestigt ist und für eine Aufnahme des Kopplungsglieds (30) ausgebildet ist.

9. Positioniereinrichtung (100) nach Anspruch 7 oder 8,
- wobei die Positioniereinrichtung (100) in Portalbauweise ausgebildet ist; und
- weiter umfassend zwei äußere Linearführungen (10B', 10B"), die benachbart und parallel zur ersten Linearführung (10A) angeordnet sind und jeweils mindestens einen Hilfswagen (11B`, 11B") entlang der ersten Linearrichtung (X) führen, wobei die zweite Linearführung (20) an die mindestens zwei Hilfswagen (11B`, 11B") gekoppelt ist; und
- zur Ausbildung der Kopplung zwischen der zweiten Linearführung (20) und den mindestens zwei Hilfswagen (11B', 11B") an jedem der mindestens zwei Hilfswagen (11B`, 11B") eine jeweilige Kopplungsblattfeder (70', 70") befestigt ist, die einer Ebene parallel zur ersten Linearrichtung (X) und zur dritten Linearrichtung (Z) angeordnet ist.

10. Verfahren zur Fertigung eines Kopplungsglieds (30) für eine Positioniereinrichtung (100), umfassend die Verfahrensschritte:
- Fertigen, aus einem Stück,
∘ eines Zentralteils (31);
∘ eines in einem Abstand zu dem Zentralteil (31) angeordneten und das Zentralteil (31) umgebenden Umgebungsteils (32), wobei das Umgebungsteil (32) einen zentralen, das Zentralteil (31) umgebenen Abschnitt (321) sowie zwei, in erster Linearrichtung (X) an den zentralen Abschnitt (321) angrenzende Endabschnitte (322) aufweist;
∘ **gekennzeichnet durch** Fertigen, aus einem Stück einer Mehrzahl von den Abstand ausbildenden Verbindungsblattfedern (33), die das Zentralteil (31) und den zentralen Abschnitt des Umgebungsteil (32) miteinander verbinden, wobei sich die Ebenen, in denen die Verbindungsblattfedern (33) angeordnet sind, in einem Zentrum (Z0) des Zentralteils (31) schneiden; und
∘ an jedem der beiden Endabschnitte (322) des Umgebungsteils (32), einer parallel zur ersten Linearrichtung (X) angeordneten Vertikalblattfeder (323), wobei sich auch die Ebenen, in denen die Vertikalblattfedern (323) angeordnet sind, in dem Zentrum (Z0) des Zentralteils (31) schneiden, so dass die Verbindungsblattfedern (33) und die Vertikalblattfedern (323) für eine Verschwenkung des Umgebungsteils (32) um eine das Zentrum (Z0) des Zentralteils (31) durchquerende und parallel zur dritten Linearrichtung (Z) befindliche Rotationsachse ausgestaltet sind.

## Claims

1. Coupling element (30) for a positioning device (100), comprising
- a central part (31);
- a surrounding part (32) arranged at a distance from the central part (31) and surrounding the central part (31), wherein the surrounding part (32) has a central section (321) surrounding the central part (31) and two end sections (322) adjoining the central section (321) in a first linear direction (X) ;
**characterized by**
- a plurality of connecting leaf springs (33) forming the distance, which connect the central part (31) and the central section of the surrounding part (32) to each other, wherein the planes in which the connecting leaf springs (33) are arranged intersect in a centre (Z0) of the central part (31); and
- a vertical leaf spring (323) arranged parallel to the first linear direction (X) is provided on each of the two end sections (322) of the surrounding part (32), wherein the planes in which the vertical leaf springs (323) are arranged also intersect in the centre (Z0) of the central part (31), so that the connecting leaf springs (33) and the vertical leaf springs (323) are configured to allow the surrounding part (32) to pivot about an axis of rotation passing through the centre (Z0) of the central part (31) and lying parallel to a third linear direction (Z).

2. Coupling element (30) according to Claim 1, wherein each of the connecting leaf springs (33) is arranged in a plane parallel to the third linear direction (Z), wherein the third linear direction (Z) is perpendicular to both the first linear direction (X) and to a second linear direction (Y) perpendicular to the first linear direction (X).

3. Coupling element (30) according to one of the preceding claims, wherein
- a mounting surface (3010) is provided on an upper side (301) of the coupling element (30);
- a mounting surface (3020) is provided on an underside (302) of the coupling element (30).

4. Coupling element (30) according to Claim 3, wherein the vertical leaf springs (323) each extend from the upper side (301) to the underside (302) and, on the underside (302), merge into a respective web-like flange (324), which forms a respective part of the mounting surface (3020) on the underside (302).

5. Coupling element (30) according to one of the preceding claims, wherein the vertical leaf springs (323) are further removed by at least the factor 2 from the centre (Z0) of the central part (31) than each of the connecting leaf springs (33).

6. Coupling element (30) according to one of the preceding claims, wherein the coupling element (30) is formed monolithically.

7. Positioning device (100), comprising
- a first linear guide (10A) for guiding a first carriage (11A) along a first linear direction (X);
- a second linear guide (20) for guiding a second carriage (21) along a second linear direction (Y) perpendicular to the first linear direction (X); and
- a coupling element (30) according to one of Claims 1 to 6, which is configured to form a coupling between the first carriage (11A) and the second linear guide (20).

8. Positioning device (100) according to Claim 7, further comprising a receiving element (40), which is fixed to the first carriage (11A) and is designed to receive the coupling element (30).

9. Positioning device (100) according to Claim 7 or 8,
- wherein the positioning device (100) is a gantry-type design; and
- further comprising two outer linear guides (10B',10B"), which are arranged adjacent and parallel to the first linear guide (10A) and each guide at least one auxiliary carriage (11B', 11B") along the first linear guide (X), wherein the second linear guide (20) is coupled to the at least two auxiliary carriages (11B', 11B"); and
- to form the coupling between the second linear guide (20) and the at least two auxiliary carriages (11B', 11B"), a respective coupling leaf spring (70', 70") is fixed to each of the at least two auxiliary carriages (11B', 11B"), which is arranged in a plane parallel to the first linear direction (X) and to the third linear direction (Z).

10. Method for producing a coupling element (30) for a positioning device (100), comprising the method steps:
- producing, from one piece,
o a central part (31);
o a surrounding part (32) arranged at a distance from the central part (31) and surrounding the central part (31), wherein the surrounding part (32) has a central section (321) surrounding the central part (31) and two end sections (322) adjoining the central section (321) in a first linear direction (X) ;
**characterized by** producing, from one piece,
o a plurality of connecting leaf springs (33) forming the distance, which connect the central part (31) and the central section of the surrounding part (32) to each other, wherein the planes in which the connecting leaf springs (33) are arranged intersect in a centre (Z0) of the central part (31); and
o a vertical leaf spring (323) arranged parallel to the first linear direction (X) on each of the two end sections (322) of the surrounding part (32), wherein the planes in which the vertical leaf springs (323) are arranged also intersect in the centre (Z0) of the central part (31), so that the connecting leaf springs (33) and the vertical leaf springs (323) are configured to allow the surrounding part (32) to pivot about an axis of rotation passing through the centre (Z0) of the central part (31) and lying parallel to the third linear direction (Z).

## Revendications

1. Organe de couplage (30) pour un dispositif de positionnement (100), comprenant
- une partie centrale (31) ;
- une partie environnante (32) disposée à une distance de la partie centrale (31) et entourant la partie centrale (31), la partie environnante (32) présentant une portion centrale (321) entourant la partie centrale (31) ainsi que deux portions d'extrémité (322) adjacentes à la portion centrale (321) dans la première direction linéaire (X) ;
- **caractérisé par**
une pluralité de ressorts à lames de liaison (33) formant la distance, lesquels relient l'une à l'autre la partie centrale (31) et la portion centrale de la partie environnante (32), les plans dans lesquels les ressorts à lames de liaison (33) sont disposés se croisant en un centre (Z0) de la partie centrale (31) ; et
- un ressort à lame vertical (323) disposé parallèlement à la première direction linéaire (X) étant prévu au niveau de chacune des deux portions d'extrémité (322) de la partie environnante (32), les plans dans lesquels les ressorts à lames verticaux (323) sont disposés se croisant également au centre (Z0) de la partie centrale (31), de telle sorte que les ressorts à lames de liaison (33) et les ressorts à lames verticaux (323) sont configurés pour un pivotement de la partie environnante (32) autour d'un axe de rotation passant par le centre (Z0) de la partie centrale (31) et se trouvant parallèlement à une troisième direction linéaire (Z).

2. Organe de couplage (30) selon la revendication 1, chacun des ressorts à lames de liaison (33) étant disposé dans un plan parallèle à la troisième direction linéaire (Z), la troisième direction linéaire (Z) étant perpendiculaire à la fois à la première direction linéaire (X) et à une deuxième direction linéaire (Y) perpendiculaire à la première direction linéaire (X).

3. Organe de couplage (30) selon l'une des revendications précédentes,
- une surface de montage (3010) étant prévue au niveau d'un côté supérieur (301) de l'organe de couplage (30) ;
- une surface de montage (3020) étant prévue au niveau d'un côté inférieur (302) de l'organe de couplage (30).

4. Organe de couplage (30) selon la revendication 3, les ressorts à lames verticaux (323) s'étendant respectivement à partir du côté supérieur (301) jusqu'au côté inférieur (302) et se prolongeant, au niveau du côté inférieur (302), par un élément rapporté (324) respectif de type nervure qui forme une partie respective de la surface de montage (3020) au niveau du côté inférieur (302) .

5. Organe de couplage (30) selon l'une des revendications précédentes, les ressorts à lames verticaux (323) étant plus éloignés au moins du facteur 2 du centre (Z0) de la partie centrale (31) que chacun des ressorts à lames de liaison (33).

6. Organe de couplage (30) selon l'une des revendications précédentes, l'organe de couplage (30) étant formé de manière monolithique.

7. Dispositif de positionnement (100), comprenant
- un premier guide linéaire (10A) servant au guidage d'un premier chariot (11A) le long d'une première direction linéaire (X) ;
- un deuxième guide linéaire (20) servant au guidage d'un deuxième chariot (21) le long d'une deuxième direction linéaire (Y) perpendiculaire à la première direction linéaire (X) ; et
- un organe de couplage (30) selon l'une des revendications 1 à 6, qui est configuré pour la réalisation d'un couplage entre le premier chariot (11A) et le deuxième guide linéaire (20).

8. Dispositif de positionnement (100) selon la revendication 7, comprenant en outre un organe de réception (40) qui est fixé au premier chariot (11A) et est réalisé pour une réception de l'organe de couplage (30) .

9. Dispositif de positionnement (100) selon la revendication 7 ou 8,
- le dispositif de positionnement (100) étant réalisé suivant une construction en portique ; et
- comprenant en outre deux guides linéaires (10B', 10B") extérieurs, qui sont disposés de manière adjacente et parallèle au premier guide linéaire (10A) et guident respectivement au moins un chariot auxiliaire (11B', 11B") le long de la première direction linéaire (X), le deuxième guide linéaire (20) étant couplé aux au moins deux chariots auxiliaires (11B', 11B") ; et
- pour la réalisation du couplage entre le deuxième guide linéaire (20) et les au moins deux chariots auxiliaires (11B', 11B"), un ressort à lame de couplage (70', 70") étant fixé à chacun des au moins deux chariots auxiliaires (11B', 11B"), lequel ressort à lame de couplage est disposé dans un plan parallèle à la première direction linéaire (X) et à la troisième direction linéaire (Z).

10. Procédé de fabrication d'un organe de couplage (30) pour un dispositif de positionnement (100), comprenant les étapes de procédé suivantes :
- fabrication, à partir d'une pièce,
o d'une partie centrale (31) ;
o d'une partie environnante (32) disposée à une distance de la partie centrale (31) et entourant la partie centrale (31), la partie environnante (32) présentant une portion centrale (321) entourant la partie centrale (31) ainsi que deux portions d'extrémité (322) adjacentes à la portion centrale (321) dans la première direction linéaire (X) ;
o **caractérisé par** la fabrication, à partir d'une pièce, d'une pluralité de ressorts à lames de liaison (33) formant la distance, lesquels relient l'une à l'autre la partie centrale (31) et la portion centrale de la partie environnante (32), les plans dans lesquels les ressorts à lames de liaison (33) sont disposés se croisant en un centre (Z0) de la partie centrale (31) ; et
o d'un ressort à lame vertical (323) disposé parallèlement à la première direction linéaire (X) au niveau de chacune des deux portions d'extrémité (322) de la partie environnante (32), les plans dans lesquels les ressorts à lames verticaux (323) sont disposés se croisant également au centre (Z0) de la partie centrale (31), de telle sorte que les ressorts à lames de liaison (33) et les ressorts à lames verticaux (323) sont configurés pour un pivotement de la partie environnante (32) autour d'un axe de rotation passant par le centre (Z0) de la partie centrale (31) et se trouvant parallèlement à la troisième direction linéaire (Z).
